# EUROPEAN PATENT APPLICATION

(11) **EP 4 621 845 A2**
(43) Date of publication of application: **24.09.2025**
(21) Application number: 25163769.0
(22) Date of filing: 14.03.2025
(51) Int. Cl.: H01L 25/065, H01L 25/10, H01L 23/498, H01L 23/538, H01L 21/56, H01L 25/00, H01L 25/18

(54) **SYSTEM AND METHODS FOR BACKSIDE POWER DELIVERY FOR SEMICONDUCTOR PACKAGES**

(30) Priority: 18.03.2024 US 202463566886 P; 03.02.2025 US 202519044620
(71) Applicant: Samsung Electronics Co., Ltd., Suwon-si, Gyeonggi-do 16677 (KR)
(72) Inventor: LI, Yan, San Jose, CA, 95134 (US); KIM, Woopoung, San Jose, CA, 95134 (US)
(74) Representative: Kuhnen & Wacker Patent- und Rechtsanwaltsbüro PartG mbB

(57) **Abstract**

Disclosed herein are device stacks, systems comprising the device stacks and manufacturing methods thereof. A device stack includes a first layer (103) with a first compute device (104), a second compute device (106), and a first connecting element (108), while a second layer (105) has a first support circuit (102). The first compute device (104) is configured to electrically connect to the second compute device (105) via the first support circuit (102) and the first connecting element (108). In some embodiments, the first support circuit (102) includes a power layer (126) on a first side of the support circuit (102), and the first support circuit (102) may include a signal network layer (126) on a second side of the first support circuit (102), the second side opposite the first side.

## Description

### TECHNICAL FIELD

The subject matter disclosed herein relates to microelectronics packaging and integrated circuits (IC) packaging. More particularly, the subject matter disclosed herein relates to a package architecture featuring backside power delivery.

### BACKGROUND

Semiconductor devices may connect to additional devices and circuitry on different substrates. Forming connections between substrates can provide increased computation. However, forming connections between substrates can cause complications. Packaging describes the general method for connecting and integrating multiple computational components together in an integrated unit, and may involve multiple different types of integrated circuits on multiple substrates which may combine into a single unit. Packaging may also describe the method for which multiple computational components within a single unit are protected by the use of various techniques to provide thermal, physical and electrical protection. Background concepts discussed herein are for informational purposes only and are not intended to limit the present disclosure. Nor should the background or field described herein be intended to limit the disclosure herein to a particular use or concept.

### SUMMARY

The invention is set out in the appended claims.

An example embodiment provides a device including a first layer with a first compute device, a second compute device, and a first connecting element, while a second layer has a first support circuit. The first compute device is configured to electrically connect to the second compute device via the first support circuit and the first connecting element. In some embodiments, the first support circuit includes a power layer on a first side of the first support circuit, and the first support circuit may include a signal network layer on a second side of the first support circuit, the second side opposite the first side. In some embodiments, the second layer includes a first redistribution layer arranged between the first compute device and the first support circuit, arranged between the first support circuit and the first connecting element, and arranged between the first support circuit and the second compute device. In some embodiments, a supporting substrate is arranged with a second redistribution layer of the second layer arranged between the first support circuit and the supporting substrate. In some embodiments, the second layer may include a second support circuit in the second layer, and the first compute device may be configured to electrically connect to the second compute device via the first support circuit, the second support circuit and the first connecting element. In some embodiments, the first compute device is a memory device and the second compute device is a processing device. In some embodiments, the first compute device is a first memory device and the second compute device is a second memory device. In some embodiments, the first compute device includes at least one of a memory device and a processing device.

In an example embodiment, a system includes a first device stack, a second device stack and a core substrate. The first device stack may have a first layer and a second layer, the first layer may have a first compute device, a second compute device and a first connecting element. The second layer may include a first support circuit electrically coupling the first compute device to the second compute device. The second device stack may have third layer and a fourth layer, the third layer including a third compute device, a fourth compute device, and a second connecting element. The fourth layer may have a second support circuit to electrically couple the third compute device to the fourth compute device. The first device stack may be positioned on a first side of the core substrate and the second device stack may be positioned on a second side of the core substrate, the second side opposite the first side. In some embodiments, the first support circuit includes a power layer on a first side of the first support circuit and a signal network layer on a second side of the first support circuit, opposite the first side. In some embodiments, the core substrate is a silicon core substrate. In some embodiments, the core substrate is a glass substrate. In some embodiments, the second layer may have a third support circuit and the fourth layer may have a fourth support circuit, wherein the first compute device electrically connects or is configured to electrically connect to the second compute device via the third support circuit and the third compute device electrically connects or is configured to electrically connect to the fourth compute device via the fourth support circuit. In some embodiments, the first device stack is coupled to the second device stack using one or more vias in the core substrate. In some embodiments, a third device stack may be embedded within the core substrate, the third device stack arranged between the first device stack and the second device stack.

In an example embodiment, a method includes forming a first layer including a first compute device, a second compute device and a first connecting element. A first redistribution layer may be formed on the first layer. A first support circuit may be positioned on the first redistribution layer. The first compute device may be coupled to the second compute device via the first support circuit. A second redistribution layer may be formed on the first support circuit, the second redistribution layer communicatively coupling the first compute device and the second compute device. The second redistribution layer may be positioned on a supporting substrate. In some embodiments, the first compute device and the second compute device may include a memory device. In some embodiments, the first support circuit includes a power layer on a first side of the first support circuit and a signal network layer on a second side of the first support circuit, the second side opposite the first side. In some embodiments, the supporting substrate is a glass substrate. In some embodiments coupling the first compute device to the second compute device via the first support circuit includes coupling the first compute device to the first support circuit, coupling the first support circuit to the first connecting element, coupling the first connecting element to a second support circuit, and coupling the second support circuit to the second compute device.

### BRIEF DESCRIPTION OF THE DRAWING

In the following section, the aspects of the subject matter disclosed herein will be described with reference to exemplary embodiments illustrated in the figures, in which:
FIG. 1A depicts a cross-sectional view of an example embodiment of a packaging structure according to various embodiments of the subject matter disclosed herein;
FIG. 1B depicts an enlarged cross-sectional view of an example embodiment of a packaging structure according to various embodiments of the subject matter disclosed herein;
FIG. 2 depicts a cross-sectional view of an example embodiment of a packaging structure according to various embodiments of the subject matter disclosed herein;
FIG. 3 depicts a cross-sectional view of an example embodiment of a packaging structure according to various embodiments of the subject matter disclosed herein;
FIG. 4 depicts a cross-sectional view of an example embodiment of a packaging structure according to various embodiments of the subject matter disclosed herein;
FIG. 5A depicts a cross-sectional view of an example embodiment of a packaging structure assembly at a first time according to various embodiments of the subject matter disclosed herein;
FIG. 5B depicts a cross-sectional view of an example embodiment of a packaging structure assembly at a second time according to various embodiments of the subject matter disclosed herein;
FIG. 5C depicts a cross-sectional view of an example embodiment of a packaging structure assembly at a third time according to various embodiments of the subject matter disclosed herein;
FIG. 5D depicts a cross-sectional view of an example embodiment of a packaging structure assembly at a fourth time according to various embodiments of the subject matter disclosed herein;
FIG. 5E depicts a cross-sectional view of an example embodiment of a packaging structure assembly at a fifth time according to various embodiments of the subject matter disclosed herein;
FIG. 5F depicts a cross-sectional view of an example embodiment of a packaging structure assembly at a sixth time according to various embodiments of the subject matter disclosed herein;
FIG. 5G depicts a cross-sectional view of an example embodiment of a packaging structure assembly at a seventh time according to various embodiments of the subject matter disclosed herein;
FIG. 5H depicts a cross-sectional view of an example embodiment of a packaging structure assembly at a seventh time according to various embodiments of the subject matter disclosed herein;
FIG. 6 depicts an example embodiment of a method of forming a package structure according to various embodiments of the subject matter disclosed herein;
FIG. 7 depicts a cross-sectional view of an example embodiment of a packaging structure assembly according to various embodiments of the subject matter disclosed herein;
FIG. 8 depicts a cross-sectional view of an example embodiment of a packaging structure assembly according to various embodiments of the subject matter disclosed herein;
FIG. 9 depicts a cross-sectional view of an example embodiment of a packaging structure assembly according to various embodiments of the subject matter disclosed herein;
FIG. 10 depicts a cross-sectional view of an example embodiment of a packaging structure assembly according to various embodiments of the subject matter disclosed herein;
FIG. 11 depicts a cross-sectional view of an example embodiment of a packaging structure assembly according to various embodiments of the subject matter disclosed herein;
FIG. 12 depicts a cross-sectional view of an example embodiment of a packaging structure assembly according to various embodiments of the subject matter disclosed herein;
FIG. 13 depicts a cross-sectional view of an example embodiment of a packaging structure assembly according to various embodiments of the subject matter disclosed herein;
FIG. 14 depicts a cross-sectional view of an example embodiment of a packaging structure assembly according to various embodiments of the subject matter disclosed herein;
FIG. 15 depicts a cross-sectional view of an example embodiment of a packaging structure assembly according to various embodiments of the subject matter disclosed herein;
FIG. 16 depicts a cross-sectional view of an example embodiment of a packaging structure assembly according to various embodiments of the subject matter disclosed herein;
FIG. 17 depicts a cross-sectional view of an example embodiment of a packaging structure assembly according to various embodiments of the subject matter disclosed herein; and
FIG. 18 depicts a cross-sectional view of an example embodiment of a packaging structure assembly according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter-Clockwise," "Three-Dimensional," etc.) may be interchangeably used with a corresponding non-capitalized version (e.g., "counter-clockwise," "three-dimensional," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, the substrates may contain circuits such as integrated circuits including central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), graphical processing units (GPUs), other forms of auxiliary processing units (xPU), artificial intelligence (AI) chips, high bandwidth memory (HBM) interfaces, and other application-specific integrated circuits (ASIC). In some embodiments, a combination of circuits may be present on a substrate. In some embodiments, a substrate may include a packaged chip.

As used herein, high bandwidth memory or HBM, may refer to a chip structure including one or more HBM modules. In some embodiments, the HBM may be manufactured by an advanced silicon node process.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be electrically connected using a via traveling through an interposer such as another substrate or chip. In some embodiments, an interconnection may be formed using connections on a surface of a substrate, such as a pad, and may use additional materials between the pads such as solder to form an interconnection.

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, hybrid bonding may be defined as bonding both conductive portions to conductive portions, such as a metal-metal bond, and bonding dielectric portions to dielectric portions such as a dielectric-dielectric bond.

As used herein, a connecting element refers to a substrate, die, or other material having one or more conductive pathways able to form connection between one or more semiconductor devices, as well as substrates, interposers, or other package structures. A connecting element may include one or more traces, the traces forming a connection pathway along the connecting element between one or more devices coupled to the connecting element. An embedded connecting element, as used herein, may refer to a connecting element in a layer within a semiconductor package, and may be used interchangeably with connecting element. An active connecting element may refer to a connecting element featuring additional features beyond connections, such as transistors, vias, and other circuit components. As used herein, a connecting element may be referred to as a connector, a bridge, or a bridge arch; an active connecting element may be referred to as an active bridge, an active bridge arch, or an active connector; and an embedded connecting element may be referred to as an embedded bridge, an embedded bridge arch, or an embedded connector.

Disclosed herein are various embodiments of devices, systems and methods related to packaging architecture to modularly create a package architecture providing a device stack with integrated modules having backside power delivery networks. A device stack architecture may include a base chip providing logic, routing, and power delivery to one or more compute devices mounted upon the base chip. Power and signals to the compute devices may be routed via the base chip, including via one or more connecting elements which may be embedded in the base chip between two or more redistribution layers. In some embodiments, the one or more connecting elements may take the form of ASIC devices which may perform functions such as logic, routing, and power management for the device stack.

A back-side power delivery network (BSPDN), also referred to as a power layer, may be formed on the back side of a support circuit, with a signal network layer formed on the front side of the same support circuit. In some embodiments, the BSPDN and signal network layer may be formed on separate substrates and transferred to the same support circuit. The BSPDN and signal network layer may be separated by a transistor layer. The transistor layer may include a plurality of transistors and may provide different functions and take different forms, including a logic layer, processors, capacitors, memory, and an ASIC device. The BSPDN, support circuit, and signal network layer may form a single monolithic structure on the same die in a semiconductor foundry process. A stacked device module may separately be formed in a semiconductor foundry process, the same semiconductor foundry process, or may have multiple components formed in multiple semiconductor foundry processes and assembled in a packaging assembly process. In some embodiments, an embedded connecting element may be between the BSPDN and the signal network layer other than a support circuit. In some embodiments, the transistor layer may be formed as part of an active connecting element. In some embodiments, a via between layers may be formed within an active connecting element or support circuit. In some embodiments, multiple connecting elements or support circuits may be formed within the base chip, and may each have their own BSPDN and signal networks.

As disclosed herein, in some embodiments, the connecting elements between devices may be active connecting elements, with the connecting element including one or more additional circuit elements such as transistors, vias, and other circuit components, such as capacitors, resistors, or any other suitable circuit elements. In some embodiments, an active connecting element may include a logic unit to provide a routing interface between one or more device stacks. In some embodiments, a connecting element may include an ASIC device. In some embodiments, a connecting element may be formed on top of the base chip between one or more compute devices.

In some embodiments, multiple device stacks may be mounted on a supporting substrate. The supporting substrate may be any appropriate substrate, including substrates made from organic materials, silicon, silicon core substrates, as well as glass substrates. The supporting substrate may be mounted on a board such that both sides of the supporting substrate may have device stacks formed upon them. In some embodiments, within the supporting substrate additional devices and components may be formed, for example additional compute devices, logic devices, routing, power delivery and communication routing may be formed on the supporting substrate.

In some embodiments, a device stack may be formed on a carrier substrate, and may include positioning one or more compute devices and one or more connecting elements upon the carrier substrate. A first encapsulation layer may be deposited to fill in spaces between the one or more compute devices and one or more connecting elements, with any excess removed via a planarization process. A first redistribution layer (RDL) may be formed upon the first encapsulation layer and the one or more compute devices and one or more connecting elements, and may include the formation of the signal network layers. One or more support circuits may then be mounted upon the first redistribution layer and signal network layers. A second encapsulation layer may be then applied to hold the support circuit in place, with a planarization step removing any excess material. A second redistribution layer (RDL) may be formed upon the back side of the one or more support circuits, and may include the BSPDN. The device stack may then be removed from the carrier and mounted on a supporting substrate, including the formation of interconnections.

As used herein, a power layer may refer to one or more layers of conductive material forming pathways in a dielectric material to provide electrical power to the various devices and components connected to the power layer. The power layer may provide a power delivery network for routing power supply lines on a back side of a transistor layer and may provide both power and reference voltages to transistors in the transistor layer. A signal network layer may refer to one or more layers of conductive material forming pathways in a dielectric material to provide communications signals to the various devices and components connected to the signal network layer. In some embodiments, the signal network layer may be referred to as the signal layer. The signal network layer may provide the signal routing between the transistor layer and the one or more compute devices, including communications signals.

As used herein, a redistribution layer may refer to one or more individual layers including one or more conductive materials such as a series of pads, bumps, vias, through-vias, traces, and other forms of connection for redistributing signals across the layer. In some embodiments, redistribution layers may be used to connect different components spread across a device package, allowing signals and power to transfer laterally across the redistribution layers. Redistribution layers may allow for indirect coupling between connections on adjacent layers by providing additional routes for the signals to transfer laterally as well as vertically.

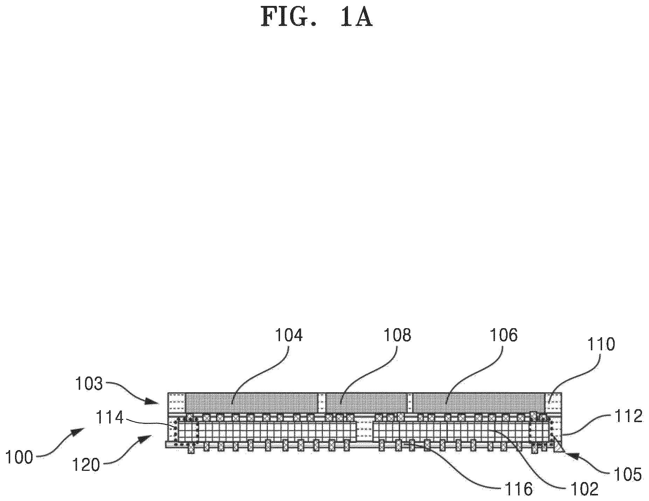

FIG. 1A depicts a cross-sectional view of an exemplary embodiment of a first device package architecture 100. The first device package architecture 100, which may be referred to as a device stack, includes a device layer 103 including a first compute device 104, a second compute device 106, and a connecting element 108 within a first encapsulation layer 110. The device layer 103 is mounted upon the base layer 105, which includes one or more support circuits 102 along with a second encapsulation layer 112 between a first RDL 114 and a second RDL 116. The second encapsulation layer 112 may be formed similarly to the first encapsulation layer 110, and may include the same material or may have a different composition. The base layer 105 is shown in further detail within an enlarged cross-section of a portion 120 of the first device package architecture 100.

In some embodiments, the compute devices including the first compute device 104 and the second compute device 106 may include a die, a core, or chiplet, or any other suitable form of circuit. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. In some embodiments, the compute devices may be various forms of memory including DRAM, SRAM, and other forms of memory. In some embodiments, the devices may include a core device, for example a processor, processing device, or other form of microcontroller to act as a controller. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit. In some embodiments, a single compute device may be used, while in other embodiments, additional compute devices may be added, for example 4, 6, 8, 16 or 32 compute devices may be added. In some embodiments, each compute device may be a single device, while in other embodiments, each compute device may be multiple devices stacked on top of each other, such as in HBM.

Additionally, the first encapsulation layer 110 may surround the first compute device 104, the second compute device 106 and the connecting element 108, the first encapsulation layer 110 may be a dielectric material such as silicon nitride (Si₃N₄) or silicon dioxide (SiO₂). In some embodiments, the first encapsulation layer 110 may provide mechanical support, such as holding the devices in places, as well as may provide electrical isolation, and may provide a thermal path for heat from the compute devices. In some embodiments, the first encapsulation layer 110 may be an epoxy molding compound or resin. The first encapsulation layer 110 may, in some embodiments, comprise one or more encapsulation layers, and may include individual encapsulation layers to encapsulate the first compute device 104 and the second compute device 106.

The connecting element 108 may comprise a semiconductor material such as silicon, although in other embodiments different semiconductors materials such as germanium may be used. The connecting element 108 may include embedded routes which may be provided as traces, wires, buried lines, or any other known suitablemeans for providing a signal connection on or within a semiconductor device. In some embodiments, the connecting element 108 may include additional circuit components for routing, monitoring, and protecting signals sent via the connecting element 108, and may form a logic chip.

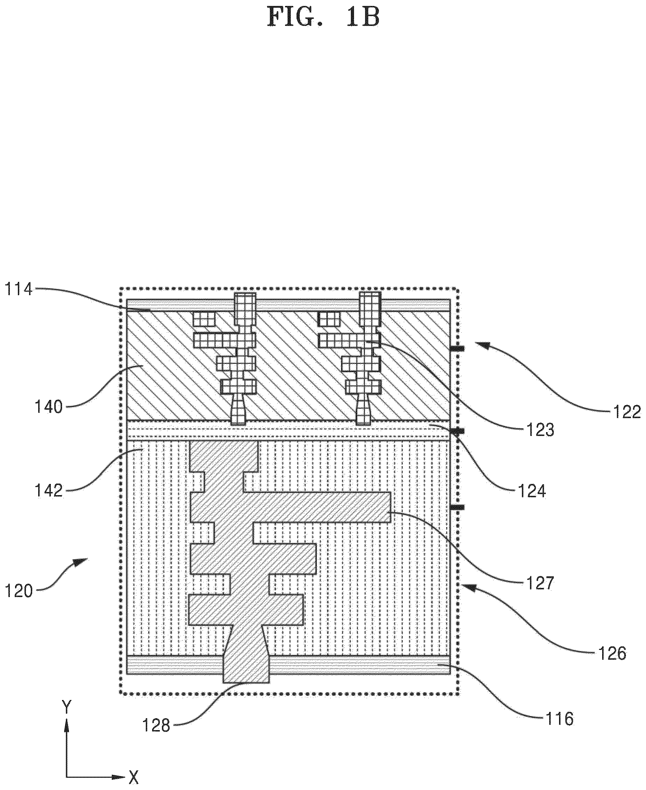

FIG. 1B depicts the enlarged cross-section of the portion 120 of the first device package architecture 100. Upon the top of the base layer 105, and between the other elements of the base layer 105 and the device layer 103 is the first RDL 114. The first RDL 114 includes a series of pads, bumps, vias, through-vias, traces, and other forms of connection for redistributing signals between the base layer 105 and the device layer 103. The connections may take the form of a mix of conductive elements and dielectric elements suitable for bonding. The first compute device 104, the second compute device 106 and the connecting element 108 may be mounted directly to the first RDL 114 and may have conductive elements such as leads and electrodes coupled to corresponding elements of the first RDL 114. A portion of the first RDL 114 may include a dielectric material suitable dielectric bonding with the device layer 103, as such a hybrid bond including bonding between both conductive portions and dielectric portions may be formed between the base layer 105 and the device layer 103.

The first RDL 114 is coupled to a signal network layer 122, which is in turn coupled to a transistor layer 124. The first RDL 114 allows for connections between the device layer 103 and the base layer 105 to be spread out from where lines and vias may emerge on the surface of the signal network layer 122, allowing additional connecting region for the connections to be formed, as well as providing additional isolation region to prevent inadvertent connections.

The signal network layer 122 may comprise a network-on-a-chip (NOC), and may provide interconnections to transport signals to and from the device layer 103. In some embodiments, the signal network layer 122 may provide packet routing. In some embodiments, the signal network layer 122 may be referred to as a signal network layer. In some embodiments, the signal network layer 122 may comprise a plurality of layers, including multiple layers providing signal routing. In some embodiments, the signal network layer 122 may comprise a plurality of conductive channels within a dielectric material, and the plurality of conductive channels may be arranged in multiple layers, with the size of the conductive channels decreasing in distance from the transistor layer 124. In some embodiments, the signal network layer 122 may have a plurality of conductive channels 123 and may include 15-20 signal network layers including conductive channels. In some embodiments, the plurality of conductive channels 123 may be a conductive material such as a metal, including copper. In some embodiments, the size of the conductive channels in a top layer of the signal network layer 122 may increase with size in distance from the transistor layer 124, while in other embodiments, the size of the conductive channels may be constant. The plurality of conductive channels 123 may be within a first dielectric material 140, which may take the form of a dielectric material such as silicon nitride (Si₃N₄), silicon dioxide (SiO₂), or any other suitable dielectric material for use with semiconductor processing.

The transistor layer 124 separates the signal network layer 122 from a power layer 126 and includes a plurality of transistors. As used herein, the transistor layer 124 may be used to refer to both the layer containing the plurality of transistors and the plurality of transistors. In some embodiments, the transistor layer 124 may act as the base logic for both the signal network layer 122 and the power layer 126. In other embodiments, the transistor layer 124 along with the signal network layer 122 and the power layer 126 provide the base logic for the device layer 103. The power layer 126 provides a power delivery network for routing power supply lines 127 on the back side of the transistor layer 124 and may provide both power and reference voltages to transistors in transistor layer 124. The power layer 126 may be referred to as a backside power delivery network, and may referred to as well as a power network, power delivery network, BSPDN, or PDN. The power layer 126, as used herein refers to one or more layers of conductive material forming pathways in a dielectric material to provide electrical power to the various devices and components connected therein. In some embodiments, the power layer 126 may include multiple different layers of power supply lines 127 routing power within a second dielectric material 142. The second dielectric material 142 may take the form of a dielectric material such as silicon nitride (Si₃N₄), silicon dioxide (SiO₂), or any other suitable dielectric material for use with semiconductor processing. In some embodiments, the power layer 126 may include 4 to 6 layers of the power supply lines 127. In some embodiments, the size of the power supply lines 127 may decrease as they approach the transistor layer 124. The power supply lines 127 may be comprised of conductive materials, including various forms of low resistive metals, such as copper, alternatively or in addition, the conductive materials may include various forms of other conductive materials, including doped carbon.

In some embodiments, the transistor layer 124 may include or be a part of one or more support circuits 102. The one or more support circuits 102 may provide a variety of functions for the device layer 103, and may include signal routing, power management, monitoring, and as well as various logic and other uses. In some embodiments, multiple of the one or more support circuits 102 may be formed within the base layer 105, while in other embodiments, a single one of the one or more support circuits 102 may be used with one or more additional devices, including computational devices such as memory, processors, input/output (I/O) chips, etc. as well as capacitors, and other suitable components. In some embodiments, the one or more support circuits 102 may take the form of an ASIC device.

The second RDL 116 forms the bottom of the power layer 126 and in some embodiments, may include a series of pads, lines, traces, and other forms of connection forming the bottom surface of the base layer 105 and may couple the power layer 126 to a supporting substrate. In some embodiments, one or more interconnections 128 taking the form of plugs and vias may be used to couple the power layer 126 to a supporting substrate. The one or more interconnections 128 of the second RDL 116 may include pads, bumps, microbumps, pillars, balls, and other forms such as controlled-collapse chip connection (C4) bumps, alone or in combination. As used herein, a C4 bump refers to a form of solder bumps placed on pads on a top surface of a substrate prior to flipping the substrate to form a flip-chip. In some embodiments, second RDL 116 may further include a dielectric material, which may include a material such as an adhesive, resin, or elastomer which may form a connection between the power layer 126 and a supporting substrate in addition to a conductive connection. In some embodiments, the combination of a conductive connection and a dielectric connection may form a hybrid bond. The supporting substrate may in turn connect to other devices and dies, and in some embodiments, may take the form of an interposer.

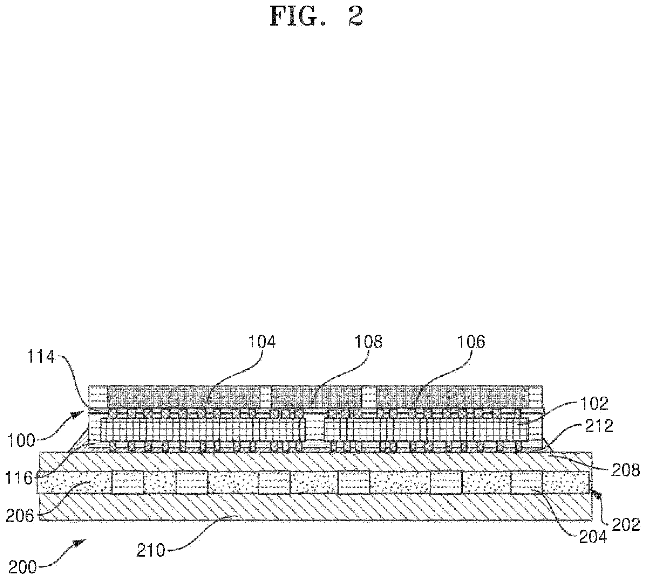

FIG. 2 depicts a cross-sectional view of a second device package architecture 200, which mounts the first device package architecture 100 on a supporting substrate 202. In some embodiments, the supporting substrate 202 may be an organic substrate such as a polymer, while in other embodiments an inorganic substrate such as a semiconductor including silicon or germanium may be used, or alternatively a SOI substrate or glass substrate may be used. In some embodiments, the supporting substrate 202 may be multiple substrates, and in some embodiments may be multiple substrates stacked upon each other. In some embodiments, multiple substrates may be shared on a single supporting substrate, and may be referred to as interposers.

In some embodiments, the supporting substrate 202 may include multiple layers. In the example of FIG. 2, the supporting substrate 202 includes an upper supportive layer 208, and a lower supportive layer 210. Furthermore, additional layers may be formed within the substrate, and may include components for use in connection with the first device package architecture 100. For example, in FIG. 2, one or more integrated stack capacitors 204 may be formed within the supporting substrate 202, between the upper supportive layer 208 and the lower supportive layer 210. A supportive molding layer 206 may be provided to encapsulate the integrated stack capacitors 204 as well as to provide mechanical support, thermal insulation, and electrical separation. In some embodiments, the supportive molding layer 206 may be one or more layers of a dielectric material, such as silicon dioxide, silicon nitride, as well as epoxy molding compounds (EMC).

In some embodiments, routing layers (not shown) may be formed on as well as within the supporting substrate 202. For example, a redistribution layer (not shown) may be formed on either or both of the upper supportive layer 208 and the lower supportive layer 210, as well as routing between the upper supportive layer 208 and the lower supportive layer 210 such as via the integrated stack capacitors 204 or between wiring layers within the supportive molding layer 206.

The supporting substrate 202 may have the first device package architecture 100 mounted upon in a variety of ways, and may include an interconnection 212 coupling the first device package architecture 100 to the supporting substrate 202. In some embodiments, the supporting substrate 202 may be connected to the first device package architecture 100 using conductive connections, and the interconnection 212 may include pads, bumps, microbumps, pillars, balls, and other forms such as C4 bumps, alone or in combination. The interconnection 212 may further include a dielectric material, which may include a material such as an adhesive, resin, or elastomer which may form a connection in addition to a conductive connection. In some embodiments, the combination of a conductive connection and a dielectric connection may form a hybrid bond.

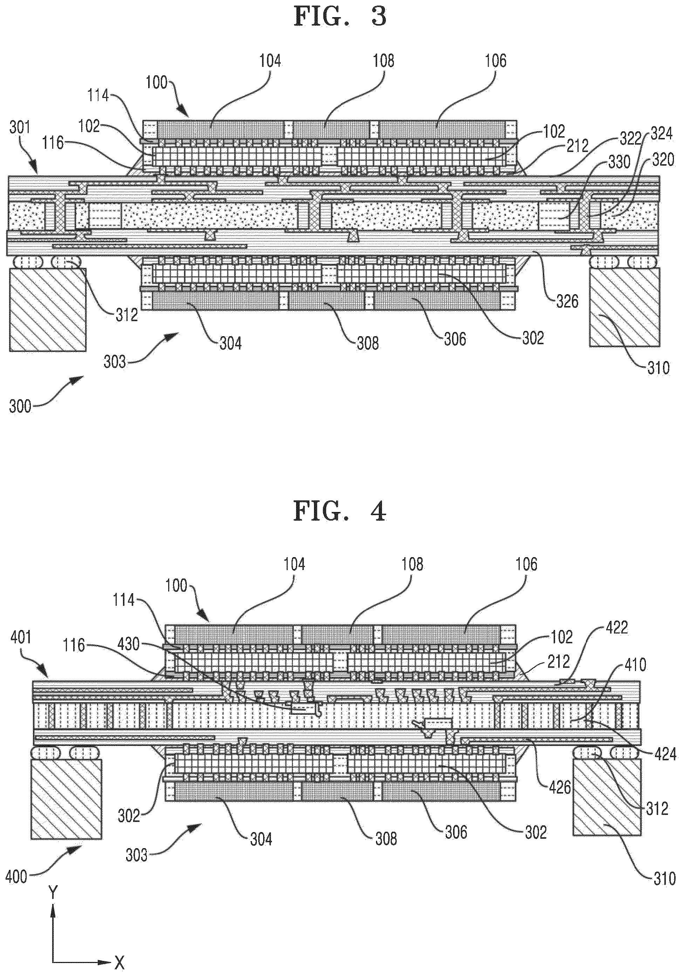

FIG. 3 depicts a cross-sectional view of a third device package architecture 300 which mounts one or more of the first device package architecture 100 on a core substrate 301. The core substrate 301 is a semiconductor substrate such as silicon or germanium, and may feature one or more elements formed within the core substrate 301.

In FIG. 3, a second device stack 303 is formed on the bottom of the core substrate 301, on a side opposite the first device package architecture 100. The second device stack 303 may be substantially the similar to the first device package architecture 100, and may include a third compute device 304, a fourth compute device 306, a second connecting element 308 in an outer layer, while one or more second support circuits 302 may be formed in an inner layer coupled to the core substrate 301. The compute devices of the second device stack 303 may be the same or similar to those of the first device package architecture 100, or may differ in purpose, type, capability or a combination thereof. The first device package architecture 100 and the second device stack 303 may be coupled to the core substrate 301 using the interconnection 212 as in the second device package architecture 200.

The core substrate 301 may include one or more upper build up layers 322 on the top side of the core substrate 301, and may include one or more lower build up layers 326 on the bottom side of the core substrate 301. Although referred to as build up layers, the one or more upper build up layers 322 and the one or more lower build up layers 326 may include one or more wiring layers and may take the form of series of pads, bumps, vias, through-vias, traces, redistribution layers and other forms of connection for redistributing signals in various combinations. The one or more upper build up layers 322 may thus provide connections to couple the first device package architecture 100 to other devices and components connected to or within the core substrate 301. Similarly, the one or more lower build up layers 326 may thus provide connections to couple the second device stack 303 to other devices and components connected to or within the core substrate 301. Furthermore, the one or more upper build up layers 322 and the one or more lower build up layers 326 may include both dielectric materials and conductive materials for forming suitable connections between the core substrate 301 and other devices.

The core substrate 301 may be mounted on a base card 310, which may take the form of a printed circuit board (PCB) or other type of circuit board. The base card 310 may be coupled to the core substrate 301 via the one or more lower build up layers 326 and a bonding layer 312. The bonding layer 312 may include conductive interconnections to electrically couple the core substrate 301 to the base card 310. Such conductive interconnections may include pads, bumps, microbumps, pillars, balls, and other forms such as C4 bumps, alone or in combination. In some embodiments, the bonding layer 312 may also include a dielectric material or an adhesive to provide additional strength and connection between the core substrate 301 and the base card 310. In some embodiments, the bonding layer 312 may provide a metallic bonding between the core substrate 301 and the base card 310, a dielectric bonding between the core substrate 301 and the base card 310, or in some embodiments a hybrid bonding between the core substrate 301 and the base card 310. In some embodiments, a dielectric material or adhesive material may be inserted using an underfill technique and form a dielectric bond on the surface of the base card 310 and the core substrate 301.

The core substrate 301 may include one or more sections of semiconductor material 320, such as silicon or germanium, which may be portions of a die, wafer or other substrate which the core substrate 301 was formed from. The core substrate 301 may furthermore include one or more embedded components 330, which may include circuit components such as capacitors and other circuit components for monitoring, controlling, or stabilizing power and signals to attached devices and dies. Additionally, one or more vias 324 may be formed within the core substrate 301. The one or more vias 324 may be made of a conductive material such as a metal and may couple the one or more upper build up layers 322 with the one or more lower build up layers 326. The one or more vias 324 thus may couple signals from the first device package architecture 100 to the second device stack 303 or the base card 310, as well as any other devices coupled to the core substrate 301.

FIG. 4 depicts a cross-sectional view of a fourth device package architecture 400 which mounts one or more of the first device package architecture 100 on a glass substrate 401. Similar to the third device package architecture 300, the first device package architecture 100 may be mounted on a top side of the glass substrate 401, while the second device stack 303 may be mounted upon a bottom side of the glass substrate 401. One or more upper glass build up layers 422 may be formed on a top side of a glass core 410 for positioning the first device package architecture 100, while one or more lower glass build up layers 426 may be formed on the bottom side of the glass core 410 for positioning the second device stack 303. The one or more upper glass build up layers 422 and the one or more lower glass build up layers 426 may be similar to the upper one or more upper build up layers 322 and the lower one or more lower build up layers 326 in FIG. 3. However, in some embodiments, the one or more upper glass build up layers 422 and the one or more lower glass build up layers 426 may also include one or more active layers, which may contain a waveguide or other light conducting components suitable for use with photonic integrated circuits.

The glass substrate 401 may also differ from the core substrate 301 by using one or more through-glass vias or TGVs 424 through the glass core 410. The TGVs 424 may be made of a conductive material such as a metal and may couple the one or more upper glass build up layers 422 with the one or more lower glass build up layers 426 using a hole through the glass substrate 401. The TGVs 424 thus may couple signals from the first device package architecture 100 to the second device stack 303 or the base card 310, as well as any other devices coupled to the glass substrate 401. Additionally, one or more grooves may be formed within the glass substrate 401 to provide space for positioning components within the glass substrate 401, such as one or more embedded glass components 430, which may include circuit components such as capacitors and other circuit components for monitoring, controlling, or stabilizing power and signals to attached devices and dies.

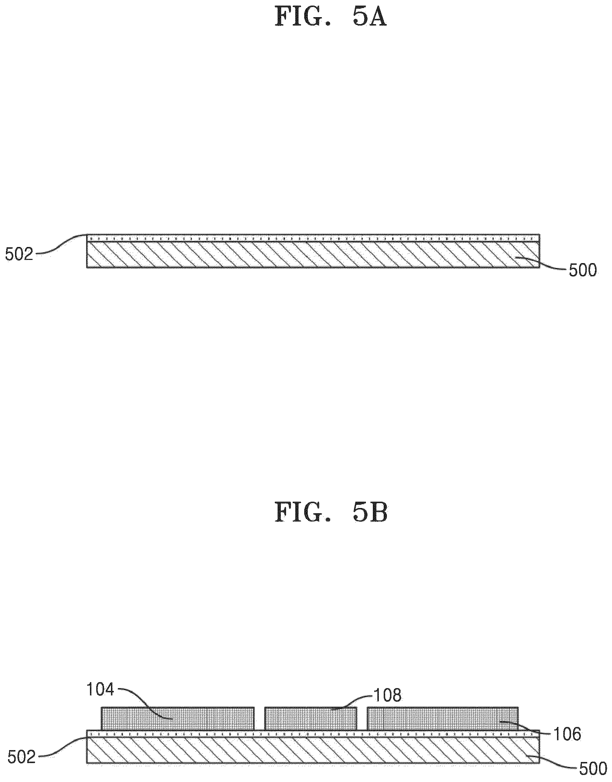

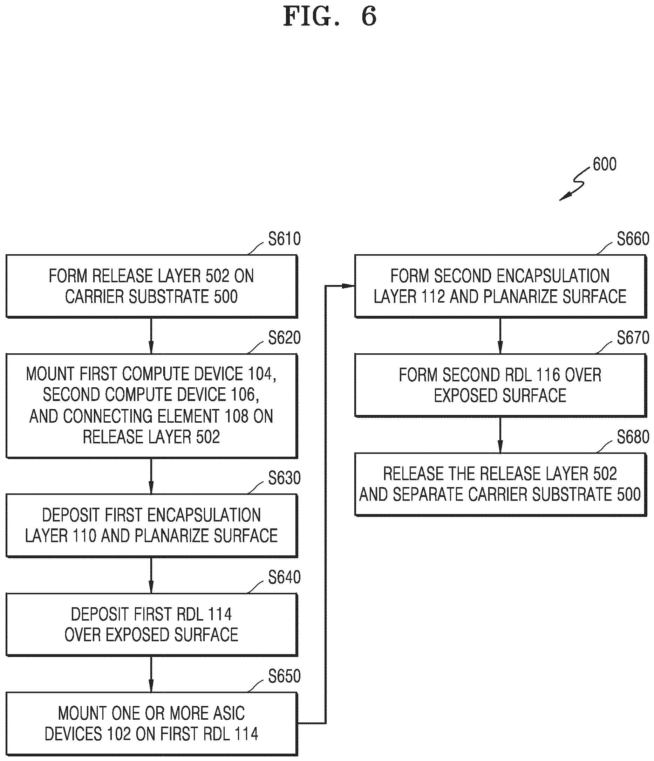

FIGS. 5A-5H depict an illustrative embodiment of a process of forming a device package architecture such as the first device package architecture 100, or any other device package architectures shown or discussed herein. FIG. 6 depicts an example embodiment of a process 600 for forming a device package assembly corresponding to the illustrative embodiment of FIGS. 5A-5H.

FIG. 5A depicts S610 in the process of FIG. 6 where a release layer 502 is formed on a carrier substrate 500. The carrier substrate 500 may be any suitable substrate, such as a glass substrate, silicon wafer, or other suitable material such as a polymer or metal blank. The release layer 502 may comprise a material such as a polymer, wax, epoxy, or resin which may act as a sacrificial layer and may be cleanly removed from the carrier substrate 500 as well as a finished device package architecture. In some embodiments, the release layer 502 may be a Die Backside Film (DBF) or other form of adhesive, or may include an adhesive material in addition to a suitable release material such as polymer, wax, epoxy, or resin.

FIG. 5B depicts S620 in the process of FIG. 6 where the computational devices of the device layer 103 are mounted upon the release layer 502. In some embodiments, a dummy layer may be first deposited on the release layer 502 to form a surface for the device layer 103, while in some embodiments, the first compute device 104, the second compute device 106, and the connecting element 108 may be mounted directly on the release layer 502. A dummy layer may include a dielectric material, such as silicon oxide, silicon nitride, epoxies, resins, and other materials suitable for use with semiconductor devices to form a top surface. The first compute device 104 and the second compute device 106 may include a die, a core, or a chiplet, as well as any other suitable form of circuit, and may be either a single device or may be multiple devices forming a stack. In some embodiments, the first compute device 104 and the second compute device 106 may be formed of the same or substantially similar compute devices, while in other embodiments, the first compute device 104 and the second compute device 106 may have different compute devices used within.

The connecting element 108 may comprise a semiconductor material such as silicon, although in other embodiments different semiconductors materials such as germanium may be used. The connecting element 108 may include embedded routes which may be provided as traces, wires, buried lines, or any other known suitable means for providing a signal connection on or within a semiconductor device. In some embodiments, the connecting element 108 may include additional circuit components for routing, monitoring, and protecting signals sent via the connecting element 108, and may form a logic chip.

The first compute device 104, the second compute device 106, and the connecting element 108 may be mounted in a flip chip configuration, such that interconnections such as pads, wiring, electrodes, etc. are formed on the side opposite the release layer 502. The first compute device 104, the second compute device 106, and the connecting element 108 may be formed in one or more front end of line (FEOL) processes, which may be performed separately from the process 600. The process 600 may be either in full or in part a back end of line (BEOL) process.

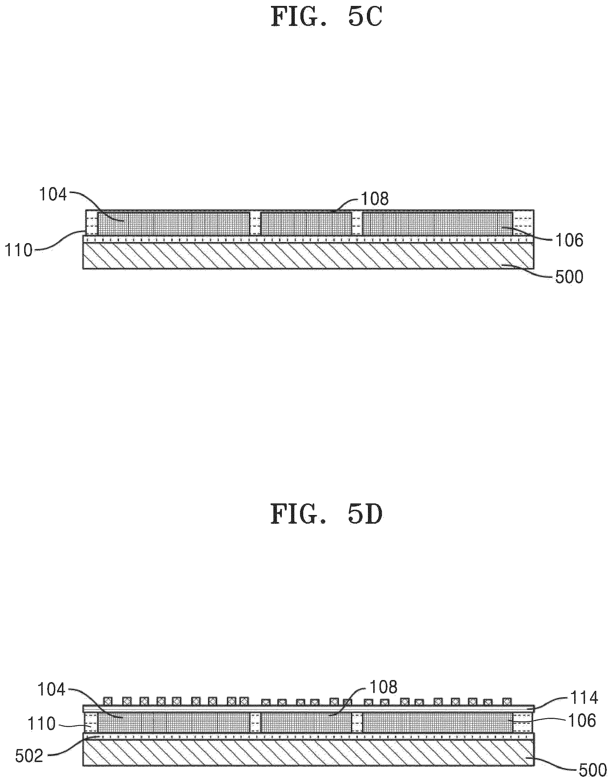

FIG. 5C depicts S630 in the process of FIG. 6 where the first encapsulation layer 110 is formed. The first encapsulation layer 110 may be deposited such that it may surround the first compute device 104, the second compute device 106 and the connecting element 108, the first encapsulation layer 110 may be a dielectric material such as silicon nitride (Si₃N₄) or silicon dioxide (SiO₂). In some embodiments, the first encapsulation layer 110 may provide mechanical support, such as holding the devices in places, as well as may provide electrical isolation, and may provide a thermal path for heat from the compute devices. In some embodiments, the first encapsulation layer 110 may be an epoxy molding compound or resin. The first encapsulation layer 110 may, in some embodiments, comprise one or more encapsulation layers, and may include individual encapsulation layers to encapsulate one or more of the first compute device 104, the second compute device 106 and the connecting element 108. In some embodiments, the first encapsulation layer 110 may be formed using one or more complementary metal-oxide-semiconductor (CMOS) processes such as chemical vapor deposition (CVD), physical vapor deposition (PVD), atomic layer deposition (ALD), passivation, diffusion, as well as lithography, etching, etc. In some embodiments, the first encapsulation layer 110 may be formed by an overmolding process such as using a resin or epoxy directly.

In some embodiments, the first encapsulation layer 110 may be formed by depositing a blanket layer of material covering both gaps between the first compute device 104, the second compute device 106 and the connecting element 108, as well as the exposed surfaces of the first compute device 104, the second compute device 106 and the connecting element 108. As such, in some embodiments, the first encapsulation layer 110 may be subject to a process to planarize the surface, the process including one or more of grinding, polishing, and smoothing processes, including chemical mechanical polishing (CMP), such that the first compute device 104, the second compute device 106 and the connecting element 108, may have their surfaces exposed. The device layer 103 may be considered fully formed after the first encapsulation layer 110 is completed.

FIG. 5D depicts S640 in the process of FIG. 6 where the first RDL 114 is formed over the device layer 103 and the signal network layer 122 may be formed. In some embodiments, the first RDL 114 may be formed using complementary metal-oxide-semiconductor (CMOS) processes, such as depositing, lithography, etching, passivation directly on the carrier substrate 500. In some embodiments, the first RDL 114 may be formed on a separate substrate and transferred to the carrier substrate 500.

The first RDL 114 includes a series of pads, bumps, vias, through-vias, traces, and other forms of connection for redistributing signals between the base layer 105 and the device layer 103. The connections may take the form of a mix of conductive elements and dielectric elements suitable for bonding. The first compute device 104, the second compute device 106 and the connecting element 108 may have the first RDL 114 directly mounted upon and may be coupled communicatively and electrically to the first RDL 114. A portion of the first RDL 114 may include a dielectric material suitable dielectric bonding with the device layer 103, as such a hybrid bond including bonding between both conductive portions and dielectric portions may be formed between the base layer 105 and the device layer 103.

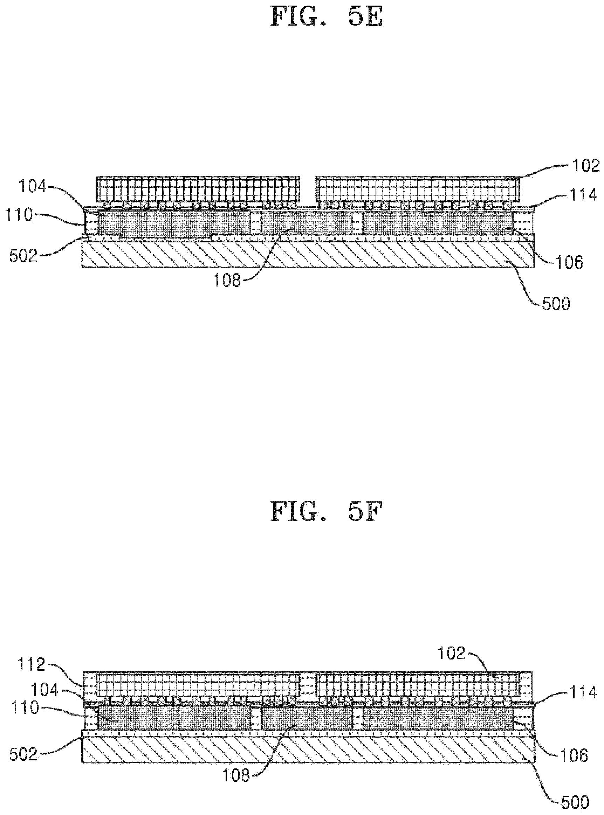

FIG. 5E depicts S650 in the process of FIG. 6 where the one or more support circuits 102 are mounted upon the first RDL 114. In some embodiments, the signal network layer 122 may be formed on the one or more support circuits 102 prior to positioning the one or more support circuits 102 on the first RDL 114, using one or more CMOS processes, including CVD, PVD, ALD, lithography, etching, passivation, and diffusion processes. The one or more support circuits 102 may be mounted on the first RDL 114 and coupled to the signal network layer 122 by bonding the first RDL 114 to the signal network layer 122. The bonding may include a metal bonding process, for example bonding corresponding pads, electrodes and wirings between the first RDL 114 and the signal network layer 122 such that metal like copper forming pads on the first RDL 114 may bond with the metal on the signal network layer 122. The bonding may furthermore include a dielectric bonding, where a dielectric surface of the first RDL 114 may bond to a corresponding dielectric surface of the signal network layer 122. Furthermore, in some embodiments, both dielectric bonding and metal bonding may be combined to form a hybrid bond. In some embodiments, a heat treatment or other thermal process may be provided to strengthen the bond between the first RDL 114 and the signal network layer 122.

The one or more support circuits 102 may provide a variety of functions such signal routing, power management, monitoring, and as well as various logics and other uses. In some embodiments, multiple of the one or more support circuits 102 may be formed within the base layer 105, while in other embodiments, a single one of the one or more support circuits 102 may be used with one or more additional devices, including computational devices such as memory, processors, input/output (I/O) chips, etc. as well as capacitors, and other suitable components to form the transistor layer 124.

In some embodiments, the signal network layer 122 may be formed either directly on the one or more support circuits 102, or may be formed separately and mounted to the one or more support circuits 102. For example, in some embodiments, the signal network layer 122 may be formed on a separate substrate and transferred to the carrier substrate 500, while in other embodiments the signal network layer 122 may be formed directly on the one or more support circuits 102, and be mounted on the first RDL 114 as part of the S650 as depicted in FIG. 5E. The signal network layer may provide interconnections to transport signals to and from the device layer 103, such as packet routing. In some embodiments, the signal network layer 122 may comprise a plurality of layers, and may include the plurality of conductive channels 123 within the first dielectric material 140. The plurality of conductive channels 123 may be arranged in multiple layers, with the size of the conductive channels increasing in distance from the first RDL 114. In some embodiments, the signal network layer 122 may include 15-20 signal network layers including the plurality of conductive channels 123. In some embodiments, the plurality of conductive channels 123 may be a conductive material such as a metal, including copper. The first dielectric material 140 may take the form of a dielectric material such as silicon nitride (Si₃N₄), silicon dioxide (SiO₂), or any other suitable dielectric material for use with semiconductor processing. The first dielectric material 140 and the plurality of conductive channels 123 may be formed by one or more appropriate CMOS processes, such as PVD, CVD, ALD, etching, lithography, passivation, and diffusion to build the individual layers of the signal network layer.

In some embodiments, the power layer 126 may be formed directly on the one or more support circuits 102 using one or more CMOS processes, including CVD, PVD, ALD, lithography, etching, passivation, and diffusion processes. The power layer 126 may include multiple different layers of power supply lines 127 routing power within a second dielectric material 142. The second dielectric material 142 may take the form of a dielectric material such as silicon nitride (Si₃N₄), silicon dioxide (SiO₂), or any other suitable dielectric material for use with semiconductor processing. In some embodiments, the power layer 126 may include 4 to 6) layers of the power supply lines 127. In some embodiments, the size of the power supply lines 127 may increase with distance from the one or more support circuits 102. The power supply lines 127 may be comprised of conductive materials, including various forms of low resistive metals, such as copper, alternatively or in addition, the conductive materials may include various forms of other conductive materials, including doped carbon.

FIG. 5F depicts S660 in the process of FIG. 6 where the second encapsulation layer 112 is formed over and around the one or more support circuits 102. The second encapsulation layer 112 may be a dielectric material such as silicon nitride (Si₃N₄) or silicon dioxide (SiO₂). In some embodiments, the second encapsulation layer 112 may provide mechanical support, such as holding the devices in places, as well as may provide electrical isolation, and may provide a thermal path for heat from the one or more support circuits 102. In some embodiments, the second encapsulation layer 112 may be an epoxy molding compound or resin. The second encapsulation layer 112 may, in some embodiments, comprise one or more encapsulation layers, and may include individual encapsulation layers to encapsulate the one or more support circuits 102. In some embodiments, the second encapsulation layer 112 may be formed using one or more CMOS processes, including CVD, PVD, ALD, passivation, diffusion, as well as lithography, etching, etc. In some embodiments, the second encapsulation layer 112 may be formed by an overmolding process such as using a resin or epoxy directly.

In some embodiments, the second encapsulation layer 112 may be formed by depositing a blanket layer of material covering both gaps between the one or more support circuits 102, as well as the exposed surfaces of the one or more support circuits 102. As such, in some embodiments, the second encapsulation layer 112 may be subject to a process to planarize the surface, the process including one or more grinding, polishing, and smoothing processes, including CMP, such that the one or more support circuits 102 may have their surfaces exposed.

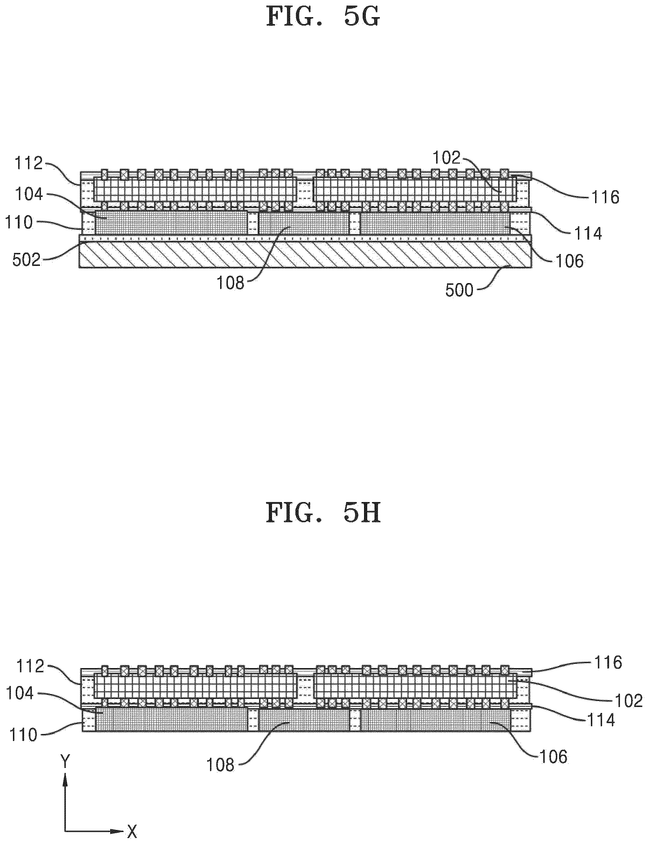

FIG. 5G depicts S670 in the process of FIG. 6 where the second RDL 116 is formed. In some embodiments, the second RDL 116 may be formed using CMOS processes, such as depositing, lithography, etching, passivation directly on the power layer 126 on the one or more support circuits 102. In some embodiments, the second RDL 116 may be formed on a separate substrate and transferred to the one or more support circuits 102.

The second RDL 116 includes a series of pads, bumps, vias, through-vias, traces, and other forms of connection for redistributing signals between the base layer 105 and a supporting substrate or interposer. The connections may take the form of a mix of conductive elements and dielectric elements suitable for bonding. A portion of the second RDL 116 may include a dielectric material suitable dielectric bonding with the one or more support circuits 102, as such a hybrid bond including bonding between both conductive portions and dielectric portions may be formed.

FIG. 5H depicts S680 in the process of FIG. 6 where thereupon the first device package architecture 100 is released from the carrier substrate 500. The carrier substrate 500 may be released, for example, by using one or more of layer release, chemical release, thermal release, or photo release techniques to release an adhesive layer coupling the carrier substrate 500 to the first device package architecture 100. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

Additionally, interconnections may be prepared for positioning the first device package architecture 100 on to a supporting substrate or interposers. The interconnections may include pads, bumps, microbumps, pillars, balls, and other forms such as C4 bumps, alone or in combination. In some embodiments, a dielectric layer or adhesive layer, including underfill may also be included.

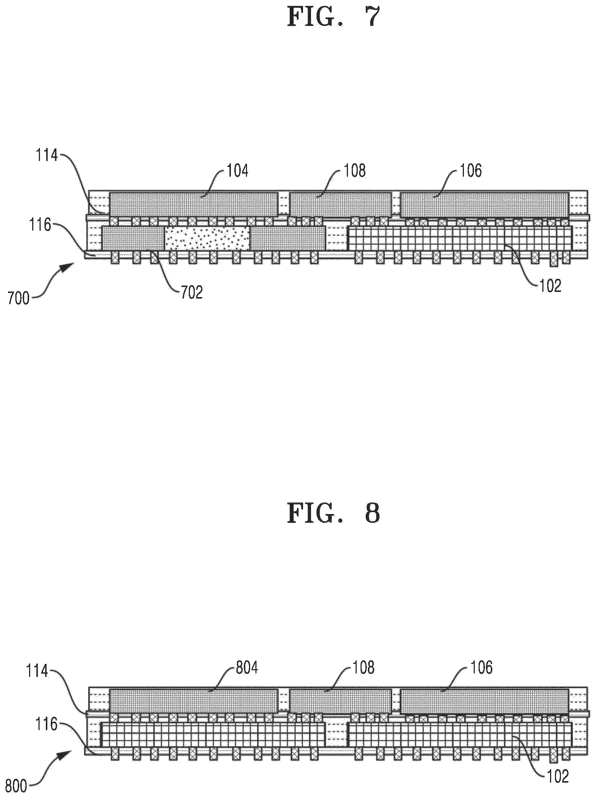

FIGS. 7-12 depict alternative formations of the device stack of the first device package architecture 100 as shown in FIG. 1.

FIG. 7 depicts a cross-sectional view of a fifth device package architecture 700, which differs from the first device package architecture 100 of FIG. 1 by including one or more clean ASIC devices 702, which are ASIC devices that do not include a power delivery network on the backside. The one or more clean ASIC devices 702 may be directly coupled with the first RDL 114 and the second RDL 116, or may have one or more intermediate layers to route signals and power to and from the one or more clean ASIC devices 702. The one or more clean ASIC devices 702 may be used in addition to the one or more support circuits 102, such that 2, 4, 6, or more of each device may be used.

FIG. 8 depicts a cross-sectional view of a sixth device package architecture 800 which differs from the first device package architecture 100 of FIG. 1 by replacing the first compute device 104 with one or more input/output (I/O) chips 804. The one or more I/O chips 804 may be used to control the I/O signals from the device stack.

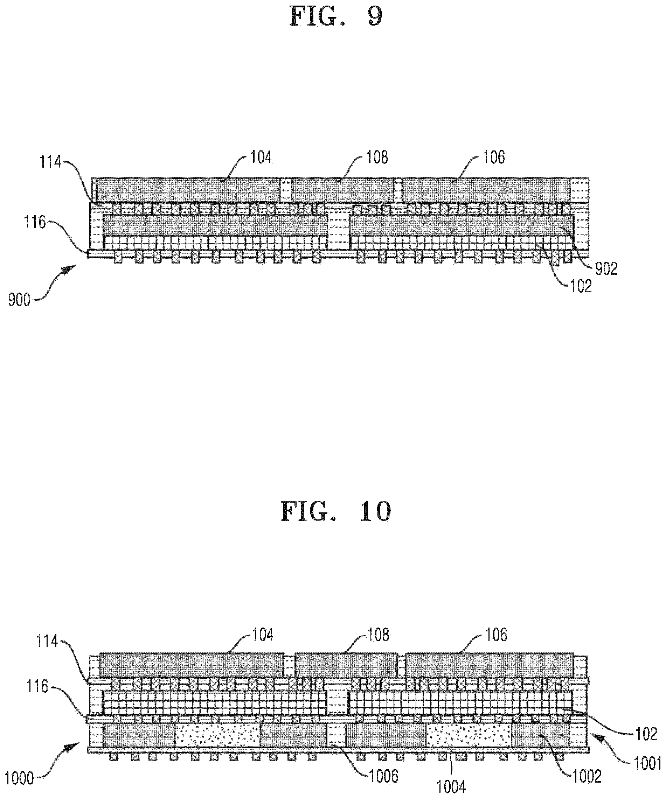

FIG. 9 depicts a cross-sectional view of a seventh device package architecture 900 which differs from the first device package architecture 100 of FIG. 1 by replacing the first compute device 104 with one or more I/O chips 804 and by including one or more embedded chips 902 bonded to the one or more support circuits 102. The one or more embedded chips 902 may include a memory device, an I/O chip, or a combination thereof. In some embodiments, one or more I/O chips can be bonded to memory devices using methods such as Wafer on Wafer (WOW) or Chip on Wafer (COW), using either micro bump based thermal compression bonding process or hybrid copper bonding processes.

FIG. 10 depicts a cross-sectional view of an eighth device package architecture 1000 which differs from the first device package architecture 100 of FIG. 1 by including a third layer 1001 with one or more integrated stack capacitor die 1002. The third layer 1001 may further include a third RDL 1004 which forms the bottom of the third layer 1001. Furthermore, a third encapsulation layer 1006 may be formed between the third RDL 1004 and the second RDL 116, within space between the one or more integrated stack capacitor die 1002. The third RDL 1004 may be formed substantially similarly to the first RDL 114 and the second RDL 116. The third encapsulation layer 1006 may be formed substantially similar to the first encapsulation layer 110 and the second encapsulation layer 112.

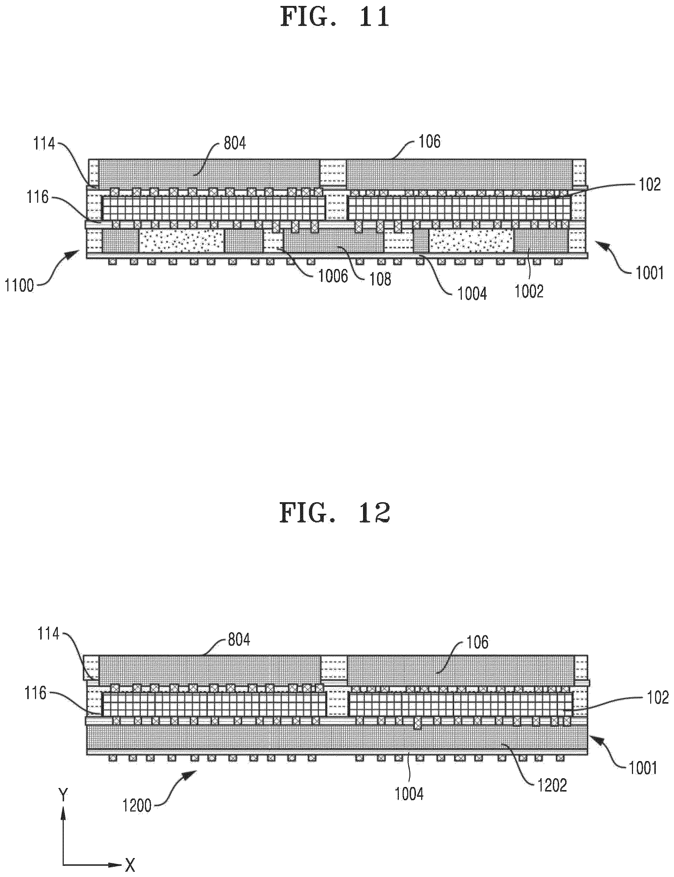

FIG. 11 depicts a cross-sectional view of a ninth device package architecture 1100 which differs from the first device package architecture 100 of FIG. 1 by replacing the first compute device 104 with one or more I/O chips 804 and by including the third layer 1001 with one or more integrated stack capacitor dies 1002 and relocating the connecting element 108 from the device layer 103 to the third layer 1001.

FIG. 12 depicts a cross-sectional view of a tenth device package architecture 1200 which differs from the first device package architecture 100 of FIG. 1 by replacing the first compute device 104 with one or more I/O chips 804 and by including the third layer 1001 with a single interposer 1202. The single interposer 1202 may be a die containing one or more chips, and may include an integrated stack capacitor.

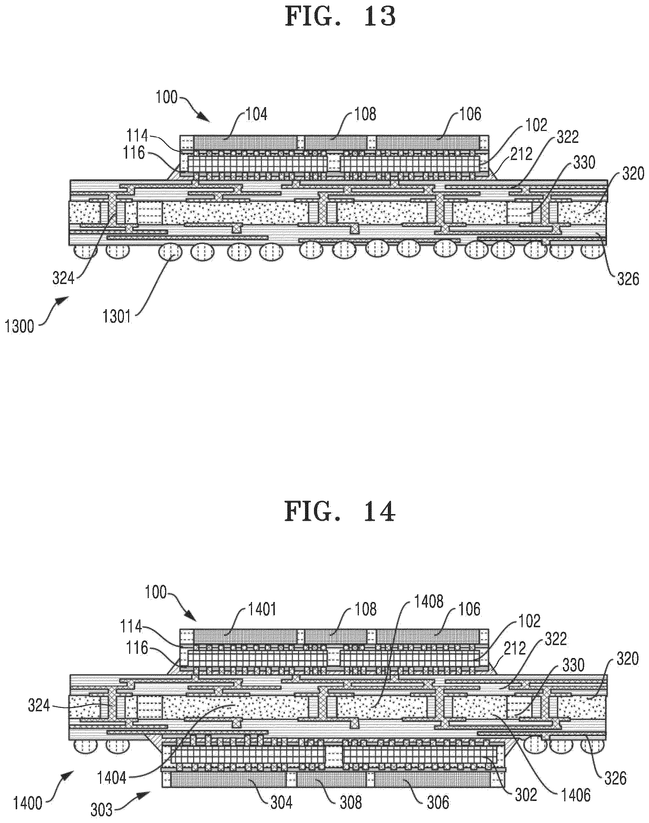

FIG. 13-15 depict alternative formations of the third device package architecture 300 as shown in FIG. 3.

FIG. 13 depicts a cross-sectional view of an eleventh device package architecture 1300, which differs from the third device package architecture 300 of FIG. 3 by arranging so that the active device stacks are on only one side of the core substrate 301. In place of the second device stack 303, a set of one or more core interconnections 1301 may be mounted on the one or more lower build up layers 326. The set of one or more core interconnections 1301 may include pads, bumps, microbumps, pillars, balls, and other forms such as C4 bumps, alone or in combination. The set of one or more core interconnections 1301 may couple directly to the base card 310, or may include one or more interposers.

FIG. 14 depicts a cross-sectional view of a twelfth device package architecture 1400, which differs from the third device package architecture 300 of FIG. 3 by embedding one or more devices within the core substrate 301. Furthermore, the first compute device 104 may be replaced by a hybrid compute device 1401, which may include functions of one or more of the previous compute devices such as memory and processing, as well as may include an I/O chip within a single compute device. In FIG. 14, the one or more devices embedded within the core substrate 301 may include a first embedded compute device 1404, a second embedded compute device 1406 and a third embedded compute device 1408. The first embedded compute device 1404, the second embedded compute device 1406, and the third embedded compute device 1408 may take the form of compute devices as described above, as well as I/O chips, ASIC devices, and any other suitable die or chips, including a connecting element.

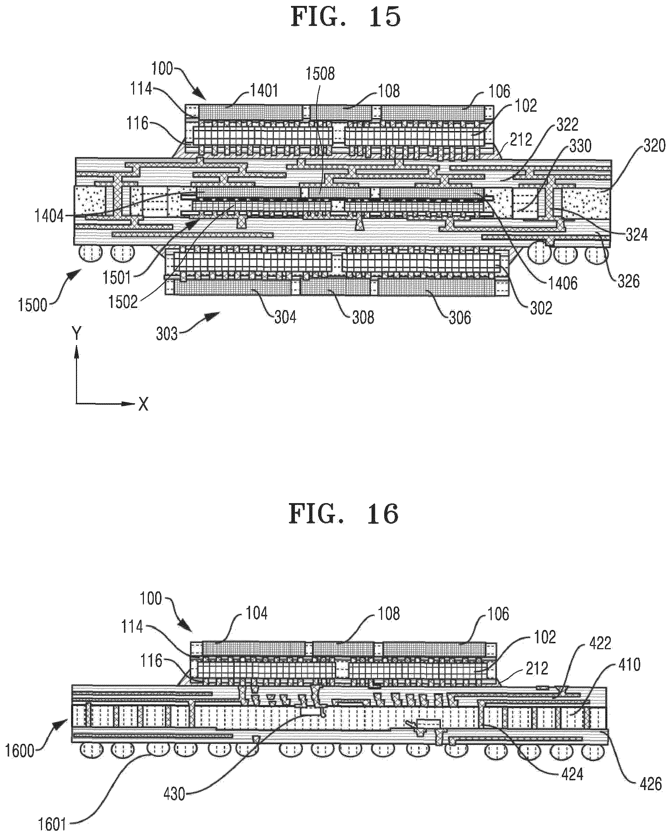

FIG. 15 depicts a cross-sectional view of a thirteenth device package architecture 1500, which differs from the third device package architecture 300 of FIG. 3 by embedding an embedded device stack 1501 within the core substrate 301. The embedded device stack 1501 may be formed similarly to the first device package architecture 100. The embedded device stack 1501 thus may may include the first embedded compute device 1404 and the second embedded compute device 1406 as well as an embedded connecting element 1508, and one or more embedded ASIC devices 1502. The one or more upper build up layers 322 and the one or more lower build up layers 326 thus may couple the embedded device stack 1501 to the second device stack 303 and the first device package architecture 100.

FIGS. 16-18 depict alternative formations of the fourth device package architecture 400 as shown in FIG. 4.

FIG. 16 depicts a cross-sectional view of a fourteenth device package architecture 1600, which differs from the fourth device package architecture 400 of FIG. 4 by arranging so that the active device stacks are on only one side of the glass substrate 401. In place of the second device stack 303, the set of one or more glass interconnections 1601 may be mounted on the one or more lower glass build up layers 426. The set of one or more core interconnections 1301 may include pads, bumps, microbumps, pillars, balls, and other forms such as C4 bumps, alone or in combination. The set of one or more glass interconnections 1601 may couple directly to the base card 310, or may include one or more interposers.

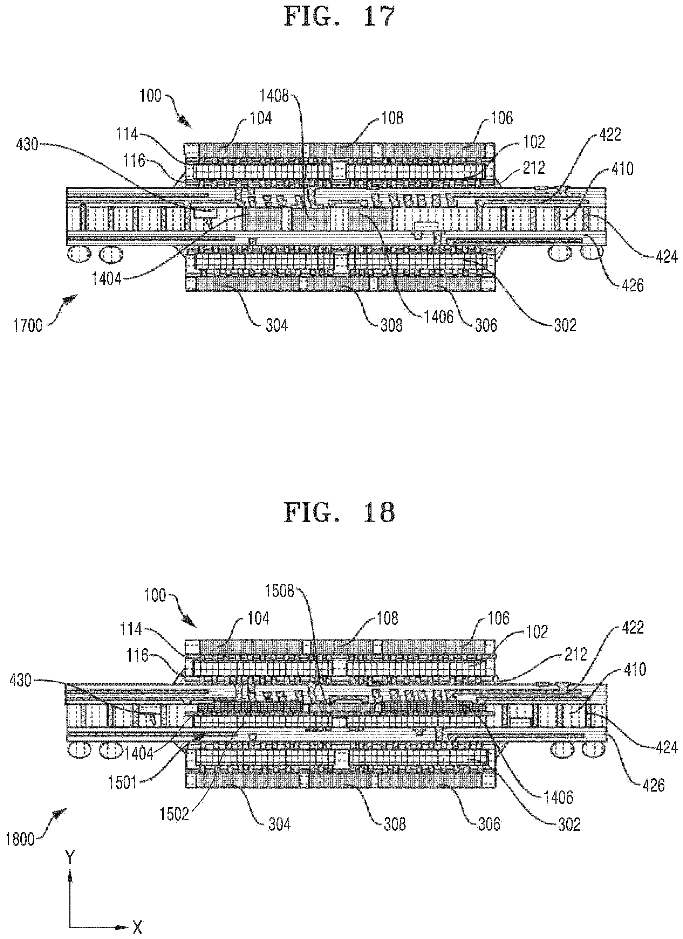

FIG. 17 depicts a cross-sectional view of a fifteenth device package architecture 1700, which differs from the fourth device package architecture 400 of FIG. 4 by embedding one or more devices within the glass substrate 401. In FIG. 17, the one or more devices embedded within the glass substrate 401 may include the first embedded compute device 1404, the second embedded compute device 1406 and the third embedded compute device 1408. The first embedded compute device 1404, the second embedded compute device 1406, and the third embedded compute device 1408 may take the form of compute devices as described above, as well as I/O chips, ASIC devices, and any other suitable die or chips, including a connecting element.

FIG. 18 depicts a cross-sectional view of a sixteenth device package architecture 1800, which differs from the fourth device package architecture 400 of FIG. 4 by embedding the embedded device stack 1501 within the glass substrate 401. The embedded device stack 1501 may be formed similarly to the first device package architecture 100. The embedded device stack 1501 thus may include the first embedded compute device 1404 and the second embedded compute device 1406 as well as the embedded connecting element 1508, and one or more embedded ASIC devices 1502. The one or more upper glass build up layers 422 and the one or more lower glass build up layers 426 thus may couple the embedded device stack 1501 to the second device stack 303 and the first device package architecture 100.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device stack comprising:
a first layer (103) including a first compute device (104), a second compute device (106) and a first connecting element (108); and
a second layer (105) including a first support circuit (102),
wherein the first compute device (104) is configured to electrically connect to the second compute device (106) via at least one of the first support circuit (102) and the first connecting element (108).

2. The device stack of claim 1, wherein,
the first support circuit (102) includes a power layer (126) on a first side of the first support circuit (102), and
the first support circuit (102) includes a signal network layer (122) on a second side of the first support circuit (102), opposite the first side.

3. The device stack of claim 1 or 2, wherein:
the second layer (105) further comprises a first redistribution layer (114) arranged between the first compute device (104) and the first support circuit (102), arranged between the first support circuit (102) and the first connecting element (108) , and arranged between the first support circuit (102) and the second compute device (106).

4. The device stack of any one of claims 1 to 3, further comprising a supporting substrate (202),
wherein the second layer (105) further comprises a second redistribution layer (116) arranged between the first support circuit (102) and the supporting substrate (202).

5. The device stack of any one of claims 1 to 4, further comprising a second support circuit (102) in the second layer (105),
wherein the first compute device (104) is configured to electrically connect to the second compute device (106) via the first support circuit (102), the second support circuit (102), and the first connecting element (108).

6. The device stack of any one of claims 1 to 5, wherein the first compute device (104) includes a memory device and the second compute device (106) includes a processing device.

7. The device stack of any one of claims 1 to 6, wherein the first compute device (104) includes a first memory device and the second compute device (106) includes a second memory device.

8. The device stack of any one of claims 1 to 7, wherein the first compute device (104) includes at least one of a memory device and a processing device.

9. A system comprising:
a first device stack according to any one of claims 1 to 8,
a second device stack (303) according to any one of claims 1 to 8; and
a core substrate (301; 401), wherein the first device stack (100) is on a first side of the core substrate (301; 401), and the second device stack (303) is on a second side of the core substrate (301; 401) opposite the first side of the core substrate (301; 401).

10. The system of claim 9, wherein the core substrate (301; 401) comprises a silicon core substrate or a glass substrate.

11. The system of claim 9 or 10, wherein the first device stack (100) is coupled to the second device stack (303) using one or more vias (324) in the core substrate (301; 401).

12. The system of any one of claims 9 to 11, further comprising a third device stack (1501),
wherein the third device stack (1501) is embedded within the core substrate (401), and the third device stack (1501) is arranged between the first device stack (100) and the second device stack (303).

13. A method of forming a device stack comprising:
forming a first layer (103) including a first compute device (104), a second compute device (106) and a first connecting element (108);
forming a first redistribution layer (114) on the first layer (103);
positioning a first support circuit (102) on the first redistribution layer (114);
coupling the first compute device (104) to the second compute device (106) via the first support circuit (102);
forming a second redistribution layer (116) on the first support circuit (102), the second redistribution layer (116) communicatively coupled to the first compute device (104) and the second compute device (106); and
positioning the second redistribution layer (116) on a supporting substrate (202).

14. The method of claim 13, wherein the device stack is according to any one of claims 1 to 8.

15. The method of claim 13 or 14, wherein coupling the first compute device (104) to the second compute device (106) via the first support circuit (102) comprises:
coupling the first compute device (104) to the first support circuit (102);
coupling the first support circuit (102) to the first connecting element (108);
coupling the first connecting element (108) to a second support circuit (102); and
coupling the second support circuit (102) to the second compute device (106).
